# DEMANDE DE BREVET EUROPEEN

(11) **EP 1 139 407 A1**
(43) Date de publication de la demande: **04.10.2001**
(21) Numéro de dépôt: 01400602.7
(22) Date de dépôt: 08.03.2001
(51) Int. Cl.: H01L 21/331, H01L 29/737

(54) **Procédé de fabrication d'un transistor bipolaire de type double-polysilicium auto-aligné à base à hétérojonction et transistor correspondant**

(30) Priorité: 27.03.2000 FR 0003845
(71) Demandeur: STMicroelectronics SA, 94250 Gentilly (FR)
(72) Inventeur: Chantre, Alain, 38180 Seyssins (FR); Dutartre, Didier, 38240 Meylan (FR); Baudry, Hélène, 38100 Grenoble (FR)
(74) Mandataire: Dossmann, Gérard

(57) **Abrégé**

Le transistor bipolaire du type double-polysilicium auto-aligné à base à hétérojonction, comprend une région semiconductrice à hétérojonction silicium-germanium 1, s'étendant sur une région active ZA d'un substrat semi-conducteur et sur une région isolante STI délimitant ladite région active, et incorporant la région de base intrinsèque du transistor; une région d'émetteur 8 située au-dessus de la région active et venant au contact de la surface supérieure de la région semi-conductrice à hétérojonction 1; une couche de polysilicium 30 formant la région de base extrinsèque du transistor, située de part et d'autre de la région d'émetteur 8, et séparée de la région semiconductrice à hétérojonction par une couche de séparation comportant une partie de liaison électriquement conductrice 74 située au voisinage extérieur de la région d'émetteur, cette partie de liaison assurant un contact électrique entre la base extrinsèque et la base intrinsèque.

## Description

L'invention concerne les composants semiconducteurs, notamment ceux destinés à s'intégrer dans les technologies haute fréquence et à très haut degré d'intégration (Technologie VLSI : "Very Large Scale Integration" en langue anglaise) et notamment les transistors bipolaires du type double-polysilicium auto-aligné à base à hétérojonction silicium-germanium, en particulier ceux ayant une base épitaxiée, et leur procédé de fabrication.

D'une manière générale, un transistor du type double-polysilicium est un transistor dont l'émetteur et la base extrinsèque sont en silicium polycristallin (polysilicium) par opposition à un transistor bipolaire simple polysilicium dont seul l'émetteur est en polysicilium.

Par ailleurs, un transistor double-polysilicium est dit "auto-aligné" lorsque la distance entre le polysilicium de la base extrinsèque et le polysilicium de l'émetteur n'est définie par aucune opération de photolithographie, c'est-à-dire notamment par aucun ajustement de deux masques de photolithographie l'un par rapport à l'autre.

Dans un procédé classique de fabrication d'un transistor bipolaire double-polysilicium auto-aligné, dont la base intrinsèque est implantée, on dépose sur une zone active d'un substrat semiconducteur ayant un type de conductivité donné (par exemple le type N) un empilement de couches comportant une couche de polysilicium fortement dopée avec un type de conductivité opposé à celui du substrat (par exemple dopé P⁺) surmontée d'une couche isolante supérieure, par exemple en dioxyde de silicium. La couche de polysilicium P⁺ est destinée à former ultérieurement la base extrinsèque du transistor. On grave ensuite l'empilement au-dessus de la zone active de façon à définir une fenêtre d'émetteur. On réalise des régions d'isolement électriques ou "espaceurs" sur les flancs de la fenêtre d'émetteur et l'on dépose du polysilicium dans la fenêtre d'émetteur de façon à former la région d'émetteur. Cette région d'émetteur est ainsi isolée de la base extrinsèque par les espaceurs internes et également par une partie de la région isolante supérieure de l'empilement sur laquelle cette région d'émetteur repose partiellement.

Durant l'opération de gravure de l'empilement, il se produit une surgravure qui a pour effet de retirer une partie du silicium de la zone active. Le contrôle et la reproductibilité de cette surgravure sont suffisants dans le contexte d'un transistor à base implantée, dans lequel l'implantation de la base intrinsèque est généralement effectuée après l'ouverture de la fenêtre d'émetteur.

La situation est différente dans un transistor à base épitaxiée, en particulier si l'on souhaite disposer d'une base intrinsèque à hétérojonction silicium-germanium. En effet, dans les transistors à base épitaxiée, on utilise généralement une épitaxie non sélective pour déposer sur la zone active et sur les régions isolantes délimitant cette zone active, une région semiconductrice au sein de laquelle sera réalisée la future base intrinsèque. On dépose alors l'empilement de couches évoqué plus haut sur cette première région semiconductrice. Or, l'épaisseur de la première région semiconductrice, c'est-à-dire l'épaisseur de la base intrinsèque, est particulièrement faible, typiquement quelques dizaines de nanomètres. Et cette base intrinsèque déjà particulièrement fine à l'origine, est inévitablement partiellement gravée lors de la surgravure résultant de la gravure de l'empilement pour la définition de la fenêtre d'émetteur. Ceci peut conduire à des dégradations du fonctionnement électrique du transistor, voire à un transistor défectueux.

Une solution consiste à n'effectuer la croissance épitaxiale de la base intrinsèque qu'une fois que la fenêtre d'émetteur a été gravée. Cependant, une telle solution nécessite l'utilisation d'une épitaxie sélective, ce qui pose d'autres problèmes technologiques plus délicats que pour une épitaxie non sélective, tels qu'un contrôle plus délicat de l'épaisseur de la base, ainsi que des difficultés plus importantes pour l'obtention d'une bonne qualité de la base épitaxiée.

L'invention vise à apporter une solution à ce problème.

Un but de l'invention est de réaliser un transistor du type double-polysilicium auto-aligné à base à hétérojonction, qui utilise à la fois une épitaxie non sélective de la base tout en évitant le problème de la surgravure mentionné ci-avant.

L'invention propose donc un procédé de fabrication d'un transistor bipolaire du type double-polysilicium auto-aligné à base à hétérojonction, dans lequel on forme par épitaxie non sélective une région semi-conductrice à hétérojonction silicium-germanium recouvrant une région active d'un substrat semiconducteur et une région isolante entourant ladite région active. On forme sur ladite région à hétérojonction, un empilement comportant une couche d'arrêt de gravure, par exemple en dioxyde de silicium obtenu à partir de tétraorthosilicate d'éthyle (TEOS). Cette couche d'arrêt de gravure est surmontée d'une couche de polysilicium ayant le même type de conductivité que la région à hétérojonction et surdopée par rapport à cette région à hétérojonction. L'empilement comporte par ailleurs au moins une couche isolante supérieure, par exemple en TEOS.

On grave ledit empilement avec arrêt sur la couche d'arrêt, de façon à définir une fenêtre d'émetteur au-dessus de la région active. On retire la portion de cette couche d'arrêt située dans le fond de la fenêtre d'émetteur et on remplace localement à la périphérie extérieure de la fenêtre d'émetteur ladite couche d'arrêt par un matériau de remplacement électriquement conducteur (par exemple un alliage de silicium-germanium fortement dopé). On forme ensuite dans ladite fenêtre d'émetteur la région d'émetteur reposant partiellement sur ladite couche isolante supérieure de l'empilement.

Ainsi, la présence de la couche d'arrêt de gravure permet d'éviter une surgravure de la région semiconductrice à hétérojonction (qui est destinée à former la base intrinsèque du transistor) qui a été préalablement obtenue par une épitaxie non sélective. En outre, la présence du matériau de remplacement électriquement conducteur disposé localement entre la région semiconductrice à hétérojonction et la couche de polysilicium (qui est destinée à former la base extrinsèque du transistor) permet d'assurer un contact électrique entre la base extrinsèque et la base intrinsèque.

Selon un mode de mise en oeuvre de l'invention, la région à hétérojonction comporte une couche d'un alliage de silicium-germanium surmontée par une couche de silicium. On choisit alors un matériau de remplacement sélectivement éliminable par rapport au silicium. Et, postérieurement à la gravure de la fenêtre d'émetteur, on effectue le retrait de la couche d'arrêt dans le fond de la fenêtre d'émetteur et localement sous la couche de polysilicium à la périphérie extérieure de la fenêtre d'émetteur. On dépose alors une couche formée dudit matériau de remplacement, puis on effectue une gravure de cette couche formée du matériau de remplacement, de façon à laisser subsister le matériau de remplacement uniquement entre la région à hétérojonction et la couche de polysilicium.

Il serait possible d'utiliser deux matériaux différents pour la couche d'arrêt et pour la couche isolante supérieure de l'empilement. On pourrait ainsi, alors que la couche isolante supérieure de l'empilement serait réalisée en TEOS, utiliser une couche d'arrêt en nitrure de silicium. Cependant, il est également possible que la couche d'arrêt soit formée du même matériau que celui formant la couche isolante supérieure de l'empilement, par exemple en TEOS. Dans ce cas, on forme en outre à la surface supérieure de l'empilement et sur les flancs de la fenêtre d'émetteur, une couche protectrice en un matériau différent de celui de la couche d'arrêt (la couche protectrice pourrait être réalisée par exemple en nitrure de silicium).

Ceci permet, lorsqu'on effectue le retrait de la couche d'arrêt, par exemple par une désoxydation humide, de ne pas endommager la couche isolante supérieure de l'empilement.

On retire ensuite ladite couche protectrice et on dépose la couche formée dudit matériau de remplacement.

Lorsque la gravure de la couche du matériau de remplacement est une gravure isotrope, le retrait local de la couche d'arrêt sous la couche de polysilicium doit être effectué sur une longueur suffisante de façon à garantir, après la gravure isotrope de la couche du matériau de remplacement, une présence suffisante de ce matériau de remplacement sous la couche de polysilicium. A titre indicatif, le retrait local de cette couche d'arrêt sous la couche de polysilicium peut être effectué sur une longueur au moins cinq fois plus grande que l'épaisseur de la couche d'arrêt et par conséquent de l'épaisseur de la couche du matériau de remplacement.

L'invention propose également un transistor bipolaire du type double-polysilicium auto-aligné à base à hétérojonction, comprenant :
- une région semiconductrice à hétérojonction silicium-germanium, s'étendant sur une région active d'un substrat semiconducteur et sur une région isolante délimitant ladite région active, et incorporant la région de base intrinsèque du transistor,
- une région d'émetteur située au-dessus de la région active et venant au contact de la surface supérieure de la région semiconductrice à hétérojonction,
- une couche de polysilicium formant la région de base extrinsèque du transistor, située de part et d'autre de la région d'émetteur, et séparée de la région semiconductrice à hétérojonction par une couche de séparation comportant une partie de liaison électriquement conductrice située au voisinage extérieur de la région d'émetteur, cette partie de liaison assurant un contact électrique entre la base extrinsèque et la base intrinsèque.

D'autres avantages et caractéristiques de l'invention apparaîtront à l'examen de la description détaillée de modes de mise en oeuvre et de réalisation, nullement limitatifs, sur lesquels :

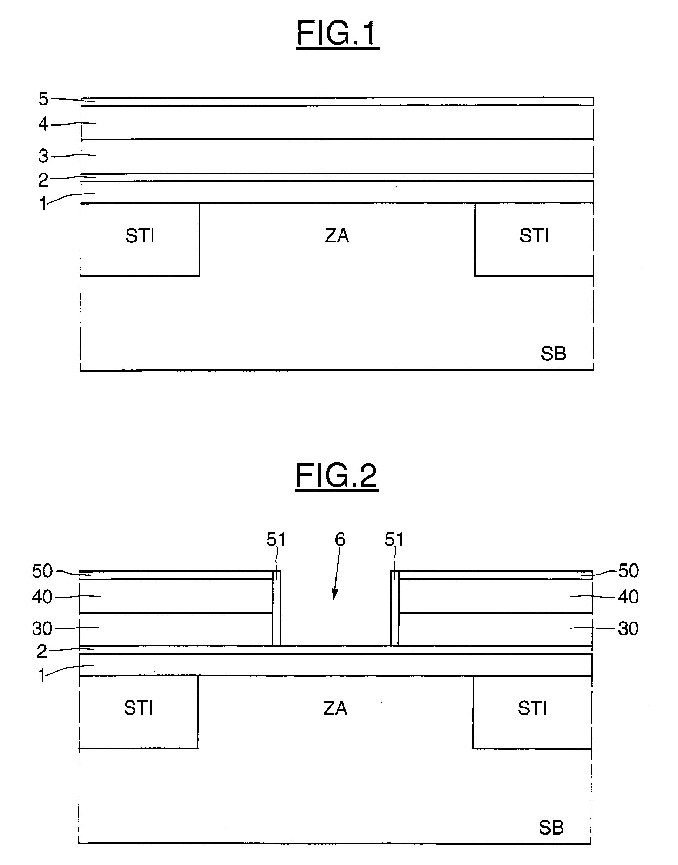

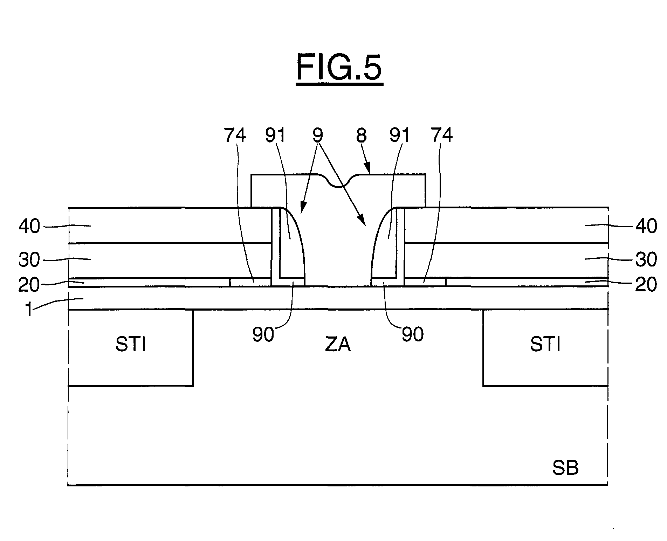

- les figures 1 à 5 illustrent très schématiquement les principales étapes d'un procédé de fabrication d'un transistor selon l'invention, la figure 5 illustrant par ailleurs également très schématiquement un mode de réalisation d'un transistor selon l'invention.

Sur la figure 1, la référence SB désigne un substrat semiconducteur, par exemple en silicium, ayant dans le cas présent un type de conductivité N. On délimite, de façon classique et connue en soi, une zone active ZA au sein de ce substrat SB en réalisant de part et d'autre de cette zone ZA des régions isolantes STI, par exemple par un procédé connu de l'homme du métier sous la dénomination de "Shallow Trench Isolation" ("isolation par tranchées peu profondes"). Cette zone active va former le collecteur intrinsèque du transistor.

On fait croître ensuite par épitaxie non sélective, une région semiconductrice à hétérojonction 1. L'épitaxie non sélective se caractérise par une croissance de cette région semiconductrice non seulement sur la zone active ZA, mais aussi sur les régions isolantes STI.

La région semiconductrice à hétérojonction silicium-germanium 1, qui a typiquement une épaisseur de quelques dizaines de nanomètres, par exemple entre 50 et 80 nanomètres, est en fait constituée de plusieurs couches superposées. Ainsi, on procède à une épitaxie non sélective d'une première couche de silicium non dopée. On épitaxie ensuite une deuxième couche formée de silicium-germanium, cette deuxième couche étant composée par exemple d'une première sous-couche de Si₁₋ₓGeₓ avec x constant compris entre 0,1 et 0,2 surmontée d'une deuxième sous-couche formée également d'un alliage de Si₁₋ₓGeₓ (avec x par exemple décroissant jusqu'à 0) et dopée P par du bore. La deuxième sous-couche est ensuite surmontée d'une couche épitaxiée de silicium dopée P par du bore.

A l'issue de cette épitaxie, réalisée typiquement à 700°C dans un réacteur de dépôt CVD ultrapropre, on obtient un empilement de couches permettant de former une base intrinsèque à hétérojonction silicium-germanium.

On dépose ensuite sur la région 1, une fine couche 2 (ayant typiquement une épaisseur comprise entre 20 et 50 nm), par exemple constituée de dioxyde de silicium obtenu à partir de tétraorthosilicate d'éthyle (TEOS).

On forme ensuite, par tout procédé classique tel qu'un dépôt dans un réacteur CVD, une couche de polysilicium 3 qui sera destinée, comme on le verra plus en détail ci-après, à former la future base extrinsèque du transistor. A cet égard, cette couche de polysilicium 3 est plus fortement dopée que la région de base intrinsèque 1. A titre indicatif, on peut prévoir une concentration de dopants P⁺ de l'ordre de 10¹⁹ à 10²⁰ at./cm³. Ce dopage de la zone de polysilicium 3 peut être effectué, soit in situ lors du dépôt, soit par implantation une fois la couche 3 déposée.

On recouvre ensuite la couche 3 d'une couche isolante supérieure 4, réalisée par exemple en oxyde TEOS.

Enfin, puisque la couche 2, qui servira comme on le verra plus en détail ci-après de couche d'arrêt de gravure, est réalisée en un matériau diélectrique analogue à celui utilisé pour la couche isolante supérieure 4, on recouvre cette couche isolante supérieure 4 d'une couche protectrice 5 en un matériau diélectrique différent de celui la constituant, par exemple du nitrure de silicium Si₃N₄.

La formation de ces couches 4 et 5 est classique dans la technologie des transistors bipolaires et les conditions de réalisation de telles couches sont bien connues de l'homme du métier.

On définit ensuite, comme illustré sur la figure 2, une fenêtre d'émetteur 6 dans l'empilement formé des couches 3, 4 et 5, au-dessus de la zone active ZA. Cette réalisation de la fenêtre d'émetteur 6 se fait par exemple classiquement par un masquage puis une gravure des différentes couches, par exemple par une attaque anisotropique par voie sèche, en particulier par plasma.

Il convient de noter ici que cette opération de gravure de l'empilement est stoppée sur la couche d'arrêt 2, en raison de la sélectivité de gravure entre le polysilicium et le dioxyde de silicium.

On réalise ensuite sur les flancs de la fenêtre d'émetteur 6 des régions isolantes 51 formées du même matériau que celui composant la couche protectrice 50, à savoir dans le cas présent du nitrure de silicium. Cette réalisation est effectuée en déposant une couche de nitrure de silicium dans la fenêtre d'émetteur, puis en gravant cette couche de nitrure de silicium de façon à obtenir les régions ou espaceurs 51. Il convient de noter ici que lors de cette opération de formation (gravure) des espaceurs 51, la couche 2 sert également de couche d'arrêt.

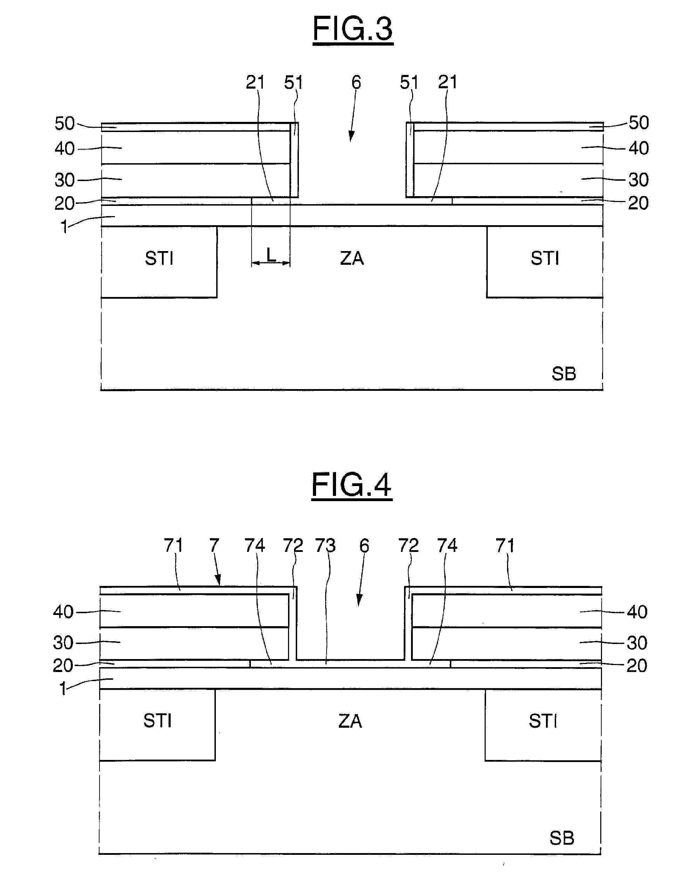

On procède ensuite, comme illustré sur la figure 3, à un retrait de la couche d'arrêt 2 située dans le fond de la fenêtre d'émetteur 6, ainsi qu'à un retrait localisé de cette couche d'arrêt 2 sous la région de polysilicium 30, et par conséquent entre cette région 30 et la région semi-conductrice 1. Ce retrait de la couche d'arrêt est effectué par une gravure humide classique. Ce retrait 21 localisé sous la couche de polysilicium 30 s'étend sur une longueur L qui est par exemple comprise entre 100 et 150 nm pour une épaisseur de la couche d'arrêt 2 de l'ordre de 20 nm.

On procède ensuite à un retrait de la couche protectrice 50 et 51 en nitrure de silicium, en utilisant également une gravure humide classique.

Puis, on dépose, par exemple par tout procédé classique tel qu'un dépôt CVD ou un dépôt en phase vapeur assisté par plasma (PECVD), une couche 7 (figure 4) d'un matériau électriquement conducteur qui est ici sélectivement éliminable par rapport au silicium de la couche 30 et au diélectrique de la couche 40.

Comme illustré sur la figure 4, cette couche 7 comporte une portion supérieure 71 s'étendant sur la portion résiduelle 40 de la couche isolante supérieure de l'empilement, une portion verticale 72 s'étendant sur les flancs de la fenêtre d'émetteur 6, une portion horizontale 73 s'étendant dans le fond de la fenêtre d'émetteur 6, et une portion 74 s'étendant sous la couche résiduelle de polysilicium 30 entre cette couche 30 et la région à hétérojonction 1, en remplacement de la couche d'arrêt localement gravée.

L'épaisseur de cette couche de matériau de remplissement est sensiblement égale à l'épaisseur de la couche d'arrêt 20.

Tout matériau électriquement conducteur et sélectivement éliminable par rapport au silicium peut convenir, en particulier un alliage de silicium-germanium fortement dopé.

A cet égard, on utilisera de préférence des alliages silicium-germanium à teneur relativement élevée en germanium, généralement de l'ordre de 10 à 50% atomique de germanium, car la sélectivité de gravure de l'alliage SiGe vis-à-vis du silicium et de SiO₂ croît avec la teneur en germanium de l'alliage.

Quant au dopage, on choisira par exemple dans le cas présent un alliage de silicium-germanium dopé P⁺ (puisque la base intrinsèque et la base extrinsèque ont le type de conductivité P) avec une concentration de dopants de l'ordre par exemple de 10²⁰ at./cm³. Ce dopage peut être effectué in situ lors du dépôt de la couche 7.

Le matériau de remplacement 7 doit être ici également sélectivement éliminable par rapport au matériau constituant la couche isolante supérieure de l'empilement, à savoir dans le cas présent le dioxyde de silicium.

On procède ensuite à une gravure isotrope sélective du matériau de remplacement 7, en utilisant toute chimie oxydante classique, par exemple une solution 40 ml HNO₃ 70% + 20 ml H₂O₂+ 5 ml HF 0,5%, ou bien une attaque plasma isotrope. Le rapport entre la longueur L de la portion 74 et l'épaisseur de la couche de matériau 7 déposée ayant été correctement choisi, une large partie au moins de la portion 74 de la couche 7 subsiste après cette gravure isotrope (figure 5).

Le procédé de fabrication du transistor selon l'invention est ensuite complété par la formation de régions d'isolement interne 9 ou espaceurs formés de deux matériaux isolants (diélectriques) différents.

En l'espèce, on dépose sur les parois et dans le fond de la fenêtre d'émetteur une couche de dioxyde de silicium TEOS, puis on dépose du nitrure de silicium. On grave ensuite le nitrure de silicium de façon à former la partie 91 des espaceurs. Cette gravure s'effectue avec arrêt sur la couche inférieure de TEOS, ce qui présente l'avantage de ne pas endommager la région de base intrinsèque sous-jacente. On procède ensuite à une désoxydation classique de la portion de couche TEOS située entre les espaceurs 9, de façon à obtenir la structure d'espaceur illustrée sur cette figure 5 et qui comporte, sous la partie en nitrure de silicium 91, une couche 90 d'oxyde TEOS.

L'émetteur 8 est ensuite déposé et repose dans sa partie inférieure sur la région de base intrinsèque et dans sa partie supérieure en partie sur la région isolante 40.

Le procédé de fabrication se poursuit alors de façon connue en soi, notamment par la réalisation des prises de contact sur l'émetteur, la base extrinsèque et le collecteur.

Sur cette figure 5, qui illustre un mode de réalisation d'un transistor selon l'invention, on voit que la région de base extrinsèque 30 repose sur la région semi-conductrice à hétérojonction 1 par l'intermédiaire d'une couche séparatrice formée de la portion résiduelle 20 de couche d'arrêt (ici en TEOS) et de la portion 74 du matériau de remplacement qui forme une partie de liaison électriquement conductrice. Cette portion 74, située au voisinage extérieur de la région d'émetteur, assure un contact électrique entre la base extrinsèque 30 et la base intrinsèque située dans la région à hétérojonction 1.

Par ailleurs, outre le caractère auto-aligné de la structure obtenue, la bonne conductivité de la partie de liaison 74 contribue à minimiser la résistance de base du transistor.

En outre, dans le procédé de fabrication selon l'invention, la couche 7 est gravée tout de suite après dépôt et ne subsiste qu'à la périphérie de l'émetteur. Le procédé selon l'invention ne prévoit donc ici ni traitement thermique, ni étape de photolithographie. En conséquence, les inconvénients liés à une contamination possible P⁺ de la base intrinsèque épitaxiée, ou à des étapes de retrait de résine, sont par conséquent inexistants.

## Revendications

1. Procédé de fabrication d'un transistor bipolaire du type double-polysilicium auto-aligné à base à hétérojonction, **caractérisé par** le fait qu'on forme par épitaxie non sélective, une région semi-conductrice à hétérojonction silicium-germanium (1) recouvrant une région active (ZA) d'un substrat semi-conducteur et une région isolante (STI) entourant ladite région active, on forme sur ladite région à hétérojonction (1), un empilement comportant une couche d'arrêt de gravure (2) surmontée d'une couche de polysilicium (3) ayant le même type de conductivité que la région à hétérojonction (1) et surdopée par rapport à cette région, et au moins une couche isolante supérieure (4), on grave ledit empilement avec arrêt sur la couche d'arrêt (2) de façon à définir une fenêtre d'émetteur (6) au-dessus de la région active, on retire la portion de cette couche d'arrêt située dans le fond de la fenêtre d'émetteur (6) et on remplace localement à la périphérie extérieure (21) de la fenêtre d'émetteur ladite couche d'arrêt par un matériau de remplacement électriquement conducteur (7), et on forme dans ladite fenêtre d'émetteur (6) la région d'émetteur (8) reposant partiellement sur ladite couche isolante supérieure.

2. Procédé selon la revendication 1, **caractérisé par** le fait que la région à hétérojonction (1) comporte une couche d'un alliage de silicium-germanium surmontée par une couche de silicium, par le fait que le matériau de remplacement (7) est sélectivement éliminable par rapport au silicium, par le fait que postérieurement à la gravure de la fenêtre d'émetteur (6) on effectue le retrait de la couche d'arrêt (2) dans le fond de la fenêtre d'émetteur et localement sous ladite couche de polysilicium (3) à la périphérie extérieure de la fenêtre d'émetteur (6), et on dépose une couche (7) formée dudit matériau de remplacement, puis on effectue une gravure de ladite couche formée du matériau de remplacement de façon à laisser subsister le matériau de remplacement (74) uniquement entre la région à hétérojonction et la couche de polysilicium.

3. Procédé selon la revendication 2, **caractérisé par** le fait que la couche d'arrêt (2) est formée du même matériau que celui formant la couche isolante supérieure (4) de l'empilement, et par le fait qu'on forme en outre à la surface supérieure de l'empilement et sur les flancs de la fenêtre d'émetteur, une couche protectrice (5) en un matériau différent de celui de la couche d'arrêt puis on effectue le retrait de ladite couche d'arrêt, on retire ladite couche protectrice et on dépose la couche formée dudit matériau de remplacement.

4. Procédé selon la revendication 3, **caractérisé par** le fait que la couche d'arrêt (2) et la couche isolante supérieure (4) de l'empilement sont formées d'oxyde de silicium, et par le fait que la couche protectrice (5) est formée de nitrure de silicium.

5. Procédé selon la revendication 2, 3 ou 4, **caractérisé par** le fait que la gravure de la couche de matériau de remplacement (7) est une gravure isotrope, par le fait que le retrait local de la couche d'arrêt sous la couche de polysilicium est effectué sur une longueur (L) au moins cinq fois plus grande que l'épaisseur de la couche du matériau de remplacement.

6. Procédé selon l'une des revendications précédentes, **caractérisé par** le fait que le matériau de remplacement (7) est formé d'un alliage de silicium-germanium fortement dopé.

7. Procédé selon l'une des revendications précédentes, **caractérisé par** le fait que la formation de la région d'émetteur (6) comporte la formation de régions d'isolement électrique (9) comportant deux matériaux isolants différents (90, 91).

8. Transistor bipolaire du type double-polysilicium auto-aligné à base à hétérojonction, comprenant
une région semiconductrice à hétérojonction silicium-germanium (1), s'étendant sur une région active (ZA) d'un substrat semi-conducteur et sur une région isolante (STI) délimitant ladite région active, et incorporant la région de base intrinsèque du transistor,
une région d'émetteur (8) située au-dessus de la région active et venant au contact de la surface supérieure de la région semi-conductrice à hétérojonction (1),
une couche de polysilicium (30) formant la région de base extrinsèque du transistor, située de part et d'autre de la région d'émetteur (8), et séparée de la région semiconductrice à hétérojonction par une couche de séparation comportant une partie de liaison électriquement conductrice (74) située au voisinage extérieur de la région d'émetteur, cette partie de liaison assurant un contact électrique entre la base extrinsèque et la base intrinsèque.

9. Transistor selon la revendication 8, **caractérisé par** le fait que la longueur (L) de la partie de liaison (74) est au moins cinq fois plus grande que son épaisseur.

10. Transistor selon la revendication 8 ou 9, **caractérisé par** le fait que la partie de liaison (74) est formée d'un alliage de silicium-germanium fortement dopé.

11. Transistor selon l'une des revendications 8 à 10, **caractérisé par** le fait que la région de base extrinsèque (30) et ladite partie de liaison (74) sont séparées de la région d'émetteur par une région d'isolement électrique (9) comportant deux matériaux isolants différents.
